# EUROPEAN PATENT APPLICATION

(11) **EP 4 513 534 A1**
(43) Date of publication of application: **26.02.2025**
(21) Application number: 22938335.1
(22) Date of filing: 19.12.2022
(51) Int. Cl.: H01L 21/67, H01L 21/687, F16J 15/16

(54) **MAGNETIC FLUID SHAFT**

(30) Priority: 20.04.2022 CN 202210417198
(71) Applicant: Jiangsu Leuven Instruments Co. Ltd, Xuzhou, Jiangsu 221300 (CN)
(72) Inventor: SANG, Kang, Xuzhou, Jiangsu 221300 (CN); HU, Dongdong, Xuzhou, Jiangsu 221300 (CN); CHEN, Longbao, Xuzhou, Jiangsu 221300 (CN); LIU, Pengfei, Xuzhou, Jiangsu 221300 (CN); WANG, Chengyi, Xuzhou, Jiangsu 221300 (CN); CHENG, Shiran, Xuzhou, Jiangsu 221300 (CN); GUO, Song, Xuzhou, Jiangsu 221300 (CN); XU, Kaidong, Xuzhou, Jiangsu 221300 (CN)
(74) Representative: Eisenführ Speiser
(86) International application number: PCT/CN2022/139931
(87) International publication number: WO 2023/202117

(57) **Abstract**

A magnetic fluid shaft, comprising an inner shaft and an outer shaft. The outer shaft sleeve is mounted on the inner shaft, and a plurality of bearings arranged at intervals in the axial direction are provided between the outer shaft and the inner shaft; a magnetic fluid is filled between at least two adjacent bearings; at least one of the outer shaft and the inner shaft is provided with a cooling channel for introducing a cooling medium. By adoption of this solution, when cooling is required, a cooling medium may be introduced into the cooling channel to reduce the temperature of the magnetic fluid shaft, so that service performance and service life of the magnetic fluid shaft in a high-temperature environment are ensured, the magnetic fluid shaft can be used in two different processes of ion beam etching and ion beam deposition, and the applicability of the magnetic fluid shaft can be greatly improved.

## Description

The present application claims priority to the Chinese Patent Application No. 202210417198.8, titled "MAGNETIC FLUID SHAFT", filed on April 20, 2022 with the China National Intellectual Property Administration, which is incorporated herein by reference in its entirety.

### FIELD

The present application relates to the technical field of shafts, and in particular to a magnetic fluid shaft.

### BACKGROUND

An operating temperature of a conventional magnetic fluid shaft ranges from - 40°C to 120°C. When the temperature exceeds 120°C, the sealing performance of the magnetic fluid cannot be guaranteed, and it may cause the bearing of the magnetic fluid shaft to overheat. As a result, it may affect the service life and usage status of the bearing, and cause the rotation of the magnetic fluid shaft unstable, seriously affecting its normal use.

### SUMMARY

An object of the present application is to provide a magnetic fluid shaft, which has an excellent high-temperature resistance.

In order to solve the above technical problem, a magnetic fluid shaft is provided in the present application, including an inner shaft and an outer shaft mounted outside the inner shaft, wherein a plurality of bearings are provided between the outer shaft and the inner shaft and spaced apart in an axial direction, a magnetic fluid is filled between at least two adjacent bearings, and at least one of the outer shaft and the inner shaft is provided with a cooling channel for introducing a cooling medium.

With this technical solution, when the cooling is required, a cooling medium can be introduced into the cooling channel to reduce the temperature of the magnetic fluid shaft, which ensures the performance and lifespan of the magnetic fluid shaft in the high-temperature environment. Thus, the magnetic fluid shaft can be used in two different processes of both ion beam etching and ion beam deposition, greatly improving applicability of the magnetic fluid shaft.

Optionally, the cooling channel is arranged in the inner shaft.

Optionally, a loading table is installed on the inner shaft.

Optionally, the inner shaft includes a shaft body and a seal plate. A surface of the shaft body facing the loading table is provided with a groove, and the seal plate is installed on the surface of the shaft body facing the loading table to block an opening of the groove. The groove forms the cooling channel.

Optionally, a loading table is installed on the inner shaft, and a seal element is provided between the inner shaft and the loading table.

Optionally, an annular base groove is formed on the shaft body and an annular hole is formed in the seal plate. The annular hole and the annular base groove correspond to each other, and the seal element can be fitted in the annular base groove through the annular hole.

Optionally, the seal element is a sealing ring or a gland packing.

Optionally, the shaft body is further provided with an inlet and an outlet, both of which are in communication with the groove.

Optionally, the number of the bearings is two.

Optionally, the inner shaft includes an end part and a cylindrical part, and the end part is located at an axial end of the cylindrical part.

Optionally, the end part is provided with a through hole that penetrates in the axial direction.

Optionally, the magnetic fluid shaft further includes a rotary joint, which is located inside the cylindrical part and is connected to the end part.

Optionally, the magnetic fluid shaft further includes a transition plate, and the rotary joint is connected to the end part via the transition plate.

Optionally, the magnetic fluid shaft further includes a temperature sensor for detecting a temperature of the inner shaft.

Optionally, the temperature sensor is installed on the end part.

Optionally, the magnetic fluid shaft further includes a baffle, and the baffle is installed on the inner shaft and/or the outer shaft to cover a clearance between the inner shaft and the outer shaft.

Optionally, an outer wall surface of the inner shaft is provided with a first stopper configured to axially stop an inner ring of the bearing.

Optionally, the baffle is provided with a second stopper configured to axially stop an outer ring of the bearing.

Optionally, an inner wall surface of the outer shaft is provided with a third stopper configured to axially stop an inner ring of the bearing.

Optionally, the magnetic fluid shaft is adapted to a process of ion beam etching and a process of ion beam deposition.

### BRIEF DESCRIPTION OF THE DRAWINGS

FIG. 1 is a schematic structural view of a magnetic fluid shaft according to an embodiment of the present application; and
FIG 2 shows a surface of an inner shaft facing a loading table.

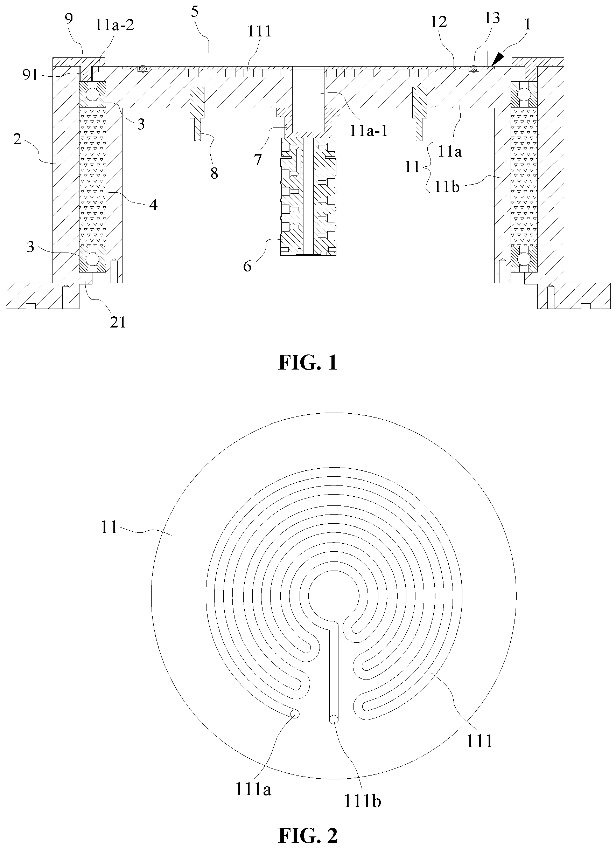

### Description of reference numerals in FIGS. 1 and 2:

1 inner shaft, 11 shaft body, 11a end part, 11a-1 through hole, 11a-2 first stopper, 11b cylindrical part, 111 groove, 111a inlet, 111b outlet, 12 seal plate, 13 seal element;
2 outer shaft, 21 third stopper;
3 bearing;
4 magnetic fluid;
5 loading table;
6 rotary joint;
7 transition plate;
8 temperature sensor;
9 baffle, 91 second stopper.

### DETAILED DESCRIPTION OF THE EMBODIMENTS

In order to better understand the technical solutions of the present application for those skilled in the art, the present application will be further described below in conjunction with the accompanying drawings and specific embodiments.

The term "several" herein refers to multiple uncertain quantities, usually two or more. In addition, when "several" is used to represent the number of certain components, it does not mean that these components are quantitatively related to each other.

The terms "first", "second", "third" and the like mentioned in this article are only for the convenience of describing two or more structures or components with the same or similar structure and/or function, and do not imply any special limitation on order and/or importance.

A magnetic fluid, also known as magnetic liquid or ferromagnetic fluid, is a colloidal material composed of solid and liquid phases. The solid phase mainly refers to magnetic solid nanoparticles, and the liquid phase refers to a liquid that can carry solid magnetic nanoparticles. The magnetic fluid has fluidity, lubricity, and sealing properties of a liquid carrier as well as the strong magnetism and other characteristics of solid nanoparticles.

The magnetic fluid sealing refers to using permanent magnets to limit the magnetic fluid between the inner and outer shafts. Due to a very small clearance between an inner shaft and an outer shaft and the particularly strong magnetic field, it can withstand a large axial thrust force to achieve sealing effect. The inner shaft, the outer shaft, and the magnetic fluid provided between the inner shaft and the outer shaft can be collectively referred to as the magnetic fluid shaft.

The magnetic fluid shaft is commonly used in the field of wafer processing to drive the wafer to rotate. A typical wafer processing technique includes ion beam etching (IBE) and ion beam deposition (IBO). The ion beam etching is a purely physical process in which ions with certain energy are used to bombard the surface of the wafer, causing atomic sputtering and achieving the purpose of etching. The ion beam deposition is a vapor deposition process in which an ion source is used to ionize the material used for deposition, and ions are then shot towards the surface of the wafer under the action of an electric field to deposit a film layer, which aims to change the surface properties of the wafer.

The requirements for the working environment are different when different processes are carried out. Generally, in case of the ion beam etching, it requires a relatively low temperature. In case of the ion beam deposition, it requires a relatively high temperature, usually above 120 °C, that is, higher than the maximum tolerance temperature of the conventional magnetic fluid shafts. This may cause the failure of magnetic fluid sealing, affecting the performance and lifespan of the bearing, and may result in the unstable rotation of the magnetic fluid shaft, seriously affecting its normal use.

In view of above, a magnetic fluid shaft is provided in embodiments of the present application, which is integrated with a cooling channel. When the cooling is required, a cooling medium can be introduced into the cooling channel to reduce the temperature of the magnetic fluid shaft, thereby ensuring the performance and lifespan of the magnetic fluid shaft in the high-temperature environment. Thus, the magnetic fluid shaft may be used in two different processes of both ion beam etching and ion beam deposition, greatly improving applicability of the magnetic fluid shaft.

Refer to FIGS. 1 and 2 for details. FIG. 1 is a schematic structural view of a magnetic fluid shaft according to an embodiment of the present application; and FIG 2 shows a surface of an inner shaft facing a loading table.

As shown in FIG. 1, a magnetic fluid shaft is provided in an embodiment of the present application, which includes an inner shaft 1 and an outer shaft 2. The outer shaft 2 is mounted outside the inner shaft 1, and several bearings 3 are arranged between the outer shaft 2 and the inner shaft 1 and spaced apart in an axial direction. A magnetic fluid 4 is filled between at least two adjacent bearings 3 to achieve a dynamic sealing between the inner shaft 1 and the outer shaft 2. At least one of the outer shaft 2 and the inner shaft 1 is provided with a cooling channel for introducing a cooling medium to cool the magnetic fluid shaft down when needed.

Herein, the type of cooling medium is not limited in the embodiments of the present application. In practice, those skilled in the art may make choice according to actual needs as long as it can meet the use requirements. For example, the cooling medium may be a gaseous medium. Alternatively, the cooling medium may also be a liquid medium, e.g., cooling water.

In addition, the number of bearings 3 to be used is also not limited in the embodiments of the present application. In practice, it can be set by those skilled in the art according to actual needs. It can be understood that, the number of bearings 3 determines the number of the magnetic fluid 4 to some extent. Assuming N bearings 3 are arranged in the axial direction, if the magnetic fluid 4 is provided between every two adjacent bearings 3, the N-1 magnetic fluid(s) 4 may be provided and spaced apart. In the solution shown in FIG. 1, two bearings 3 arranged at interval in the axial direction may be provided between the inner shaft 1 and the outer shaft 2. The bearing 3 may be a ball bearing, a roller bearing, etc., which is used to achieve a relative rotation between the inner shaft 1 and the outer shaft 2. The magnetic fluid 4 may be arranged in an area between the two bearings 3. In this case, only a single magnetic fluid 4 may be provided.

In actual use, the outer shaft 2 is a fixed shaft for realizing installation and fixation of the magnetic fluid shaft. The inner shaft 1 can rotate relative to the outer shaft 2. The inner shaft 1 is further used to install a loading table 5 on which a part to be processed, e.g., a wafer, can be held, and the installation method includes but is not limited to screw connection, welding, clamping, etc. Taking the wafer processing as an example, during the process of ion beam deposition, the loading table 5 may be heated to meet the temperature conditions required for ion beam deposition. Therefore, the inner shaft 1 is closer to the heat source than the outer shaft 2. In view of this, the cooling channel may be directly provided in the inner shaft 1 to cool the inner shaft 1 closer to the heat source, so as to more directly control the temperatures of the bearing 3 and the magnetic fluid 4.

The form of the cooling channel can be various. In specific implementation, those skilled in the art may design the cooling channel according to actual needs as long as it can achieve the technical purpose of cooling the magnetic fluid 4.

In the solution shown in FIGS. 1 and 2, the inner shaft 1 may include a shaft body 11 and a seal plate 12. A surface of the shaft body 11 facing the loading table 5 may be provided with a groove 111, and the seal plate 12 may be installed on the surface of the shaft body 11 facing the loading table 5 to block an opening of the groove 111. In that case, the groove 111 can form the cooling channel. The shaft body 11 may be further provided with an inlet 111a and an outlet 111b, both of which can be in communication with the groove 111 for inflowing and outflowing of the cooling medium.

Herein, the method of connection between the seal plate 12 and the shaft body 11 is not limited in the embodiments of the present application. In practice, those skilled in the art may make a choice according to actual needs, as long as the reliability of connection between the seal plate 12 and the shaft body 11 can be ensured and the cooling medium can only flow along an extension direction of the groove 111 (sealing requirements) after the connection is completed. In addition, the shape of the groove 111 in the extension direction is not limited in the embodiments of the present application. In specific implementation, those skilled in the art may design the shape of the groove according to actual needs, or with reference to FIG. 2.

Further, a seal element 13 may be provided between the inner shaft 1 and the loading table 5 to improve the sealing performance at the connection between the inner shaft 1 and the loading table 5. The seal element 13 may be implemented as a rubber ring, gland packing, etc.

Specifically, an annular groove may be formed in one of the inner shaft 1 and the loading table 5, and the seal element 13 may be located in the annular groove to ensure the stability of the seal element 13 in the installed state. In the solution shown in FIG. 1, the annular groove may be formed on the inner shaft 1, specifically, may be formed on the shaft body 11 and the seal plate 12. That is, the annular groove may include two parts, namely, an annular base groove on the shaft body 11 and an annular hole on the seal plate 12. The annular hole and the annular base groove may correspond to each other, and the seal element 13 may be fitted in the annular base groove through the annular hole.

Further referring to FIG. 1, in the embodiment of the present application, the inner shaft 1 may include an end part 11a and a cylindrical part 11b, and the end part 11a is located at an axial end of the cylindrical part 11b. With this arrangement, the end part 11a and the cylindrical part 11b can define a cavity, which is not only beneficial to the weight reduction of the inner shaft 1 and formation of an installation space for installing other parts, but also beneficial to reduction of the volume of the magnetic fluid shaft provided in the present application and thereby increase of the integration level of the equipment.

The end part 11a may be provided with a through hole 11a-1 that penetrates in the axial direction for wiring of the loading table 5. The seal between the through hole 11a-1 and the external environment can be achieved by the aforementioned seal element 13.

Further, a temperature sensor 8 for detecting the temperature of the inner shaft 1 may be provided. The cooling medium can be controlled to be in circulation or to be not in circulation based on the temperature measured by the temperature sensor 8. Herein, the structure or form of the temperature sensor is not limited in the embodiments of the present application as long as it can realize the above functions.

In some optional embodiments, the temperature sensor 8 may be a contact sensor, for example, a thermocouple, etc. In this case, the temperature sensor 8 can be directly installed on the inner shaft 1, for example, on the end part 11a of the inner shaft 1 (see FIG. 1). In some other optional embodiments, the temperature sensor 8 may also be a non-contact sensor, for example, an infrared temperature sensor, etc. In this case, the location of the temperature sensor 8 may be variable.

Further, a rotary joint 6 and a transition plate 7 may be further provided, both of which can be located inside the cylindrical part 11b, that is, located inside the aforementioned cavity. The rotary joint 6 may be connected to the end part 11a via the transition plate 7. With this arrangement, the transition plate 7 may be arranged to adjust the installation position of the rotary joint 6, and it can further solve the problem of interface mismatch when the rotary joint 6 is directly connected to the end part 11a. That is, two axial ends of the transition plate 7 may have two forms of interfaces, one of which may be used to connect with the end part 11a, and the other of which may be used to connect with the rotary joint 6.

It can be understood that the aforementioned transition plate 7 may not be provided. In this case, the rotary joint 6 can be directly connected to the end part 11a, without affecting transmission of the rotational driving force to the inner shaft 1 from the rotary joint 6.

The aforementioned rotary joint 6 is a joint integrated with gas connection, electric connection and liquid connection, inside which cooling medium inlet and outlet pipes in communication with the cooling channel, a signal line linked to the temperature sensor 8, and other structural components (for example, an inert gas connecting pipe) may be provided.

Further referring to FIG. 1, the magnetic fluid shaft provided in the present application may further include a baffle 9, which may be installed on the inner shaft 1 and/or the outer shaft 2 to cover the clearance between the inner shaft 1 and the outer shaft 2, so as to function as a dust guard.

Moreover, an outer wall surface of the inner shaft 1 may be provided with a first stopper 11a-2, and the baffle 9 may be provided with a second stopper 91. The first stopper 11a-2 and the second stopper 91 are respectively used to axially stop the inner ring and the outer ring of the bearing 3. This stopping manner may refer to the case that bearing 3 is located on the upper side in FIG. 1, where the first stopper 11a-2 is used to axially stop the inner ring of the bearing 3 and the second stopper 91 is used to axially stop the outer ring of the bearing 3. The bearing 3 located on the lower side in the embodiment of FIG. 1 may be axially stopped by a third stopper 21 provided on the outer shaft 2.

As can be seen from the above, a magnetic fluid shaft is provided in the present application, which has good high temperature resistance and a wide range of operating temperatures. It is tested that the operating temperature of the magnetic fluid shaft can reach - 40°C to 400°C, with a longer service life. Moreover, the magnetic fluid shaft can be used in two different processes of ion beam etching and ion beam deposition.

The above is merely the preferred embodiments of the present application. It should be noted that, for those skilled in the art, several improvements and modifications can be made without departing from the principle of the present application. These improvements and modifications should also be considered as falling in the scope of the present application.

## Claims

1. A magnetic fluid shaft, comprising:
an inner shaft (1); and
an outer shaft (2) mounted outside the inner shaft (1), wherein
a plurality of bearings (3) are provided between the outer shaft (2) and the inner shaft (1) and are spaced apart in an axial direction, a magnetic fluid (4) is filled between at least two adjacent bearings (3), and at least one of the outer shaft (2) and the inner shaft (1) is provided with a cooling channel for introducing a cooling medium.

2. The magnetic fluid shaft according to claim 1, wherein
the cooling channel is arranged in the inner shaft (1).

3. The magnetic fluid shaft according to claim 2, wherein
a loading table (5) is installed on the inner shaft (1).

4. The magnetic fluid shaft according to claim 3, wherein
the inner shaft (1) comprises a shaft body (11) and a seal plate (12), a surface of the shaft body (11) facing the loading table (5) is provided with a groove (111), and the seal plate (12) is installed on the surface of the shaft body (11) facing the loading table (5) to block an opening of the groove (111); and
the groove (111) forms the cooling channel.

5. The magnetic fluid shaft according to claim 4, wherein
a seal element (13) is provided between the inner shaft (1) and the loading table (5).

6. The magnetic fluid shaft according to claim 5, wherein
an annular base groove is formed on the shaft body (11), and an annular hole is formed in the seal plate (12); and
the annular hole and the annular base groove correspond to each other, and the seal element (13) is fitted in the annular base groove through the annular hole.

7. The magnetic fluid shaft according to claim 5, wherein
the seal element (13) is a sealing ring or a gland packing.

8. The magnetic fluid shaft according to claim 4, wherein
the shaft body (11) is further provided with an inlet (111a) and an outlet (111b), both of which are in communication with the groove (111).

9. The magnetic fluid shaft according to claim 1, wherein
the number of the bearings (3) is two.

10. The magnetic fluid shaft according to any one of claims 1 to 9, wherein
the inner shaft (1) comprises an end part (11a) and a cylindrical part (11b), and the end part (11a) is located at an axial end of the cylindrical part (11b).

11. The magnetic fluid shaft according to claim 10, wherein
the end part (11a) is provided with a through hole (11a-1) that penetrates in the axial direction.

12. The magnetic fluid shaft according to claim 10, further comprising a rotary joint (6), wherein
the rotary joint (6) is located inside the cylindrical part (11b) and is connected to the end part (11a).

13. The magnetic fluid shaft according to claim 12, further comprising a transition plate (7), wherein
the rotary joint (6) is connected to the end part (11a) via the transition plate (7).

14. The magnetic fluid shaft according to claim 10, further comprising a temperature sensor (8) for detecting a temperature of the inner shaft (1).

15. The magnetic fluid shaft according to claim 14, wherein
the temperature sensor (8) is installed on the end part (11a).

16. The magnetic fluid shaft according to any one of claims 1 to 9, further comprising a baffle (9), wherein the baffle (9) is installed on the inner shaft (1) and/or the outer shaft (2) to cover a clearance between the inner shaft (1) and the outer shaft (2).

17. The magnetic fluid shaft according to claim 16, wherein
an outer wall surface of the inner shaft (1) is provided with a first stopper (11a-2) configured to axially stop an inner ring of the bearing (3).

18. The magnetic fluid shaft according to claim 16, wherein
the baffle (9) is provided with a second stopper (91) configured to axially stop an outer ring of the bearing (3).

19. The magnetic fluid shaft according to any one of claims 1 to 9, wherein
an inner wall surface of the outer shaft (2) is provided with a third stopper (21) configured to axially stop an inner ring of the bearing (3).

20. The magnetic fluid shaft according to any one of claims 1 to 9, wherein
the magnetic fluid shaft is adapted to a process of ion beam etching and a process of ion beam deposition.
